# FASCICULE DE BREVET EUROPEEN

(11) **EP 0 962 869 B1**
(45) Date de publication et mention de la délivrance du brevet: **10.03.2004**
(21) Numéro de dépôt: 99401203.7
(22) Date de dépôt: 19.05.1999
(51) Int. Cl.: G06F 13/40, H03K 19/0175

(54) **Circuit d'interface bistandard pour liaison série**
Zwei-Standard-Schnittstellenschaltung für serielle Verbindung
Dual-standard interface circuit for serial link

(30) Priorité: 02.06.1998 FR 9806878
(43) Date de publication de la demande: 08.12.1999
(73) Titulaire: ABB CONTROL, F-69680 Chassieu (FR)
(72) Inventeur: Jaffrnnou, Marc, 69003 Lyon (FR)
(74) Mandataire: Laget, Jean-Loup

(56) Documents cités:
- DE-A- 4 113 920
- DE-A- 4 133 636
- BARREAU A.: " Versatile optoelectronic logic circuit elements" ELECTRONIC ENGINEERING., vol. 58, no. 712, avril 1986 (1986-04), pages 39-46, XP002097127 LONDON GB
- HANS SORENSEN: "Opto-isolator developments are making your design chores simpler." EDN ELECTRICAL DESIGN NEWS., vol. 18, no. 24, 20 décembre 1973 (1973-12-20), pages 36-44, XP002097128 NEWTON, MASSACHUSETTS US

## Description

La présente invention concerne un circuit d'interface permettant de recevoir et d'envoyer des informations sur une liaison série, et elle s'applique, d'une manière générale, à tout système pouvant communiquer avec un autre système, machine ou dispositif périphérique par l'intermédiaire d'une liaison série.

Usuellement, un tel circuit d'interface est intercalé entre un émetteur-récepteur asynchrone universel (bien connu sous la désignation UART) d'un système hôte et un connecteur d'un câble multiconducteur d'une liaison série, et il est souvent conçu pour procurer une isolation galvanique entre ledit émetteur-récepteur et le connecteur.

On connaît déjà un circuit d'interface du genre sus-indiqué, qui comprend, côté émetteur-récepteur, un premier, un second et un troisième coupleur opto-électronique et , côté câble de liaison, un circuit convertisseur apte à convertir des signaux logiques TTL provenant de l'émetteur-récepteur en signaux logiques différentiels à destination d'une paire de conducteurs du câble de liaison et, inversement, des signaux logiques différentiels provenant de ladite paire de conducteurs dudit câble de liaison en signaux logiques TTL à destination dudit émetteur-récepteur, conformément au standard RS485. Dans ce circuit d'interface connu, ledit circuit comporte :
a) une entrée de données pour recevoir, via le premier coupleur opto-électronique, des signaux logiques de données en provenance de l'émetteur-récepteur,
b) une entrée de commande pour recevoir, via le second coupleur opto-électronique, des signaux de commande en provenance de l'émetteur-récepteur,
c) une sortie de données pour envoyer, via le troisième coupleur opto-électronique, des signaux logiques de données à l'émetteur-récepteur, ladite sortie étant connectée à une première électrode d'un émetteur de lumière du troisième coupleur opto-électronique, une seconde électrode dudit émetteur de lumière étant relié par une première résistance à une source de tension continue;
d) une première entrée/sortie reliée à ladite source de tension continue par une seconde résistance et destinée à être connectée directement à une première broche du connecteur reliant le circuit d'interface audit câble de liaison; et
e) une seconde entrée/sortie reliée à une masse électrique par une troisième résistance et destinée à être connectée directement à une seconde broche dudit connecteur.

Le circuit connu d'interface décrit ci-dessus permet donc au système hôte dans lequel il est incorporé, de communiquer avec un autre système, machine ou dispositif périphérique par l'intermédiaire d'une liaison série isolée du type RS485. Toutefois, il existe également des systèmes qui sont conçus pour communiquer via une liaison série du type RS232.

La présente invention a donc pour but de fournir un circuit d'interface du type décrit plus haut, initialement conçu pour fonctionner avec une liaison série du type RS485, et qui soit également capable de fonctionner avec une liaison série du type RS232, moyennant l'ajonction de quelques composants très simples.

A cet effet, partant du circuit connu d'interface décrit plus haut, le circuit d'interface selon l'invention est caractérisé en ce que la première électrode dudit émetteur de lumière du troisième coupleur opto-électronique est reliée par une quatrième résistance à ladite source de tension continue, et en ce que la seconde électrode dudit émetteur de lumière est reliée à une première extrémité d'une cinquième résistance dont la seconde extrémité est destinée à être raccordée directement à une troisième broche du connecteur, grâce à quoi, en prenant comme référence de potentiel la première entrée/sortie du circuit convertisseur, le circuit d'interface est apte à émettre sur la deuxième entrée/sortie du circuit convertisseur des signaux logiques de données conformes au standard RS232 et à recevoir sur la seconde extrémité de la cinquième résistance, des signaux logiques de données conformes au standard RS232.

Dans ces conditions, c'est le câblage du circuit d'interface au connecteur du câble de la liaison série qui détermine le type de liaison RS485 ou RS232 que l'on désire. Ainsi, en raccordant la première et la seconde entrée/sortie du circuit convertisseur respectivement à une première et à une seconde broche du connecteur d'un premier câble, il est possible de transmettre, en émission et en réception, les signaux différentiels conformes au standard RS485 respectivement sur les conducteurs du premier câble qui sont raccordés respectivement à la première et à la seconde broche du connecteur de ce premier câble. D'un autre côté, en raccordant la première et la seconde entrée/sortie dudit circuit convertisseur et la seconde extrémité de la cinquième résistance respectivement à une première, une seconde et une troisième broche du connecteur d'un second câble, il est possible de transmettre des données sur ce second câble conformément au standard RS232. Plus précisément, pour l'émission en RS232, les données sont transmises sur le conducteur du second câble qui est raccordé à la seconde broche précitée du connecteur, elle-même raccordée à la seconde entrée/sortie dudit circuit convertisseur, tandis que pour la réception en RS232, les données sont reçues sur le conducteur du second câble qui est raccordé à la troisième broche précitée dudit connecteur, elle-même raccordée à la seconde extrémité de la cinquième résistance, le potentiel de référence pour les signaux en émission et en réception étant, dans les deux cas, porté par le conducteur du second câble qui est raccordé à la première broche précitée du connecteur, elle-même raccordée à la première entrée/sortie du circuit convertisseur.

D'autres caractéristiques et avantages de l'invention ressortiront à la lecture de la description suivante d'un mode de réalisation du circuit d'interface, donné à titre d'exemple en référence aux dessins annexés dans lesquels :
- la figure 1 est un schéma fonctionnel général montrant l'implantation du circuit d'interface selon l'invention entre un émetteur-récepteur à synchrone universel et le connecteur d'un câble de liaison;
- la figure 2 est un schéma électrique montrant un circuit d'interface connu conçu pour fonctionner en liaison série RS485;
- la figure 3 est un chronogramme illustrant le fonctionnement du circuit d'interface connu de la figure 2, en mode réception dans la partie gauche de la figure et en mode émission dans la partie droite de la figure;
- la figure 4 est un schéma électrique montrant le circuit d'interface selon l'invention, conçu pour fonctionner aussi bien en liaison série RS485 qu'en liaison série RS232;
- les figures 5 et 6 sont des chronogrammes semblables à celui de la figure 3, illustrant le fonctionnement du circuit d'interface de la figure 4 respectivement en liaison série RS485 et en liaison série RS232.

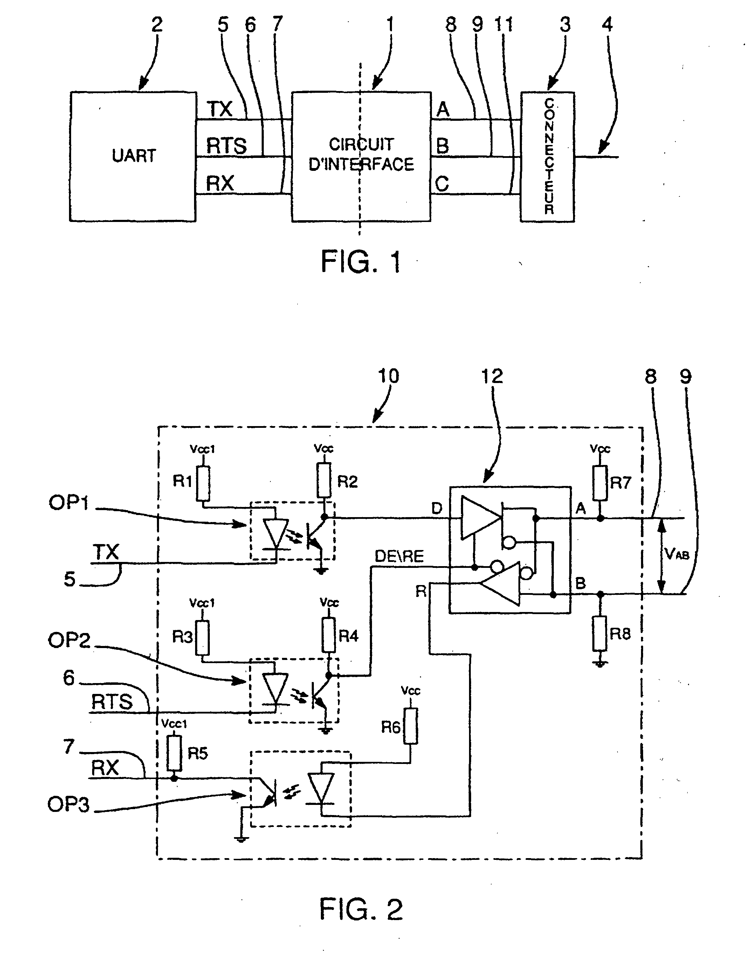

Dans la figure 1, le numéro de référence 1 désigne le circuit d'interface selon l'invention, qui est intercalé entre l'émetteur-récepteur asynchrone universel (UART) 2 d'un système hôte (non montré), par exemple un ordinateur, et le connecteur 3 d'un câble multiconducteur 4. Le circuit d'interface 1 est relié à l'émetteur-récepteur 2 par des conducteurs 5, 6 et 7 qui véhiculent respectivement le signal TX (données en émission en provenance de l'émetteur-récepteur 2), le signal RTS (signal de commande en provenance de l'émetteur-récepteur 2) et le signal RX (données en réception vers l'émetteur-récepteur). D'autre part, le circuit d'interface 1 est raccordé au connecteur 3 par deux conducteurs 8 et 9 pour une liaison série RS485 et, en plus des conducteurs 8 et 9, par un troisième conducteur 11 pour une liaison série RS232. Dans le cas d'une liaison série RS485, aussi bien les données émises en direction du câble 4 que les données reçues en provenance du câble 4 sont acheminées par les deux conducteurs 8 et 9 sur la forme de signaux différentiels. Dans le cas d'une liaison RS232, les données émises envoyées au câble 4 sont acheminées par le conducteur 9, tandis que les données reçues à travers le câble 4 sont acheminées par le conducteur 11 et, en émission comme en réception, le potentiel présent sur le conducteur 8 est pris comme potentiel de référence.

Dans la figure 1, la ligne verticale en pointillés symbolise une isolation galvanique qui est obtenue, comme on le verra plus loin, par des coupleurs opto-électroniques.

La figure 2 montre un circuit d'interface connu 10, qui est conçu pour une liaison série RS485 et qui peut être intercalé entre un émetteur-récepteur asynchrone universel et un connecteur d'une façon semblable à celle représentée dans la figure 1, à l'exception du conducteur 11, qui dans ce cas, n'existe pas. Le circuit d'interface 10 comprend essentiellement, comme composant principal, un circuit convertisseur 12 apte à convertir des signaux logiques en signaux différentiels conformément à la norme EIA485 (RS485). Le circuit convertisseur 12 comporte une entrée de données D, une entrée de commande DE\RE une sortie de données R, une première entrée/sortie A et une seconde entrée/sortie B.

L'entrée de données D est raccordée, par l'intermédiaire d'un premier coupleur opto-électronique OP1, à la ligne 5 acheminant les données TX émises par l'émetteur-récepteur 2. L'entrée de commande DE\RE est raccordée, par l'intermédiaire d'un second coupleur opto-électronique OP2, à la ligne 6 acheminant les signaux de commande RTS émis par l'émetteur-récepteur 2. La sortie de données R est raccordée, par l'intermédiaire d'un troisième coupleur opto-électronique OP3, à la ligne 7 acheminant à l'émetteur-récepteur 2 les données RX reçues à travers le câble 4. L'entrée/sortie A est raccordée par le conducteur 8 à une première broche du connecteur 3, tandis que l'autre entrée/sortie B est raccordée par le conducteur 8 à une seconde broche du connecteur 3.

Dans la figure 2, les résistances R₁ à R₈ sont des résistances de polarisation. Les résistances R₁, R₃ et R₅ sont connectées à une première source de tension continue Vcc1, tandis que les résistances R₂, R₄, R₆ et R₇ sont connectées à une seconde source de tension continue Vcc, et la résistance R₈ à la masse

Le circuit convertisseur 12 est un circuit standard sur le marché de l'électronique, par exemple un circuit du type 75176 fabriqué notamment par la société TEXAS INSTRUMENTS. Un tel circuit fonctionne conformément aux tables de vérité suivantes :

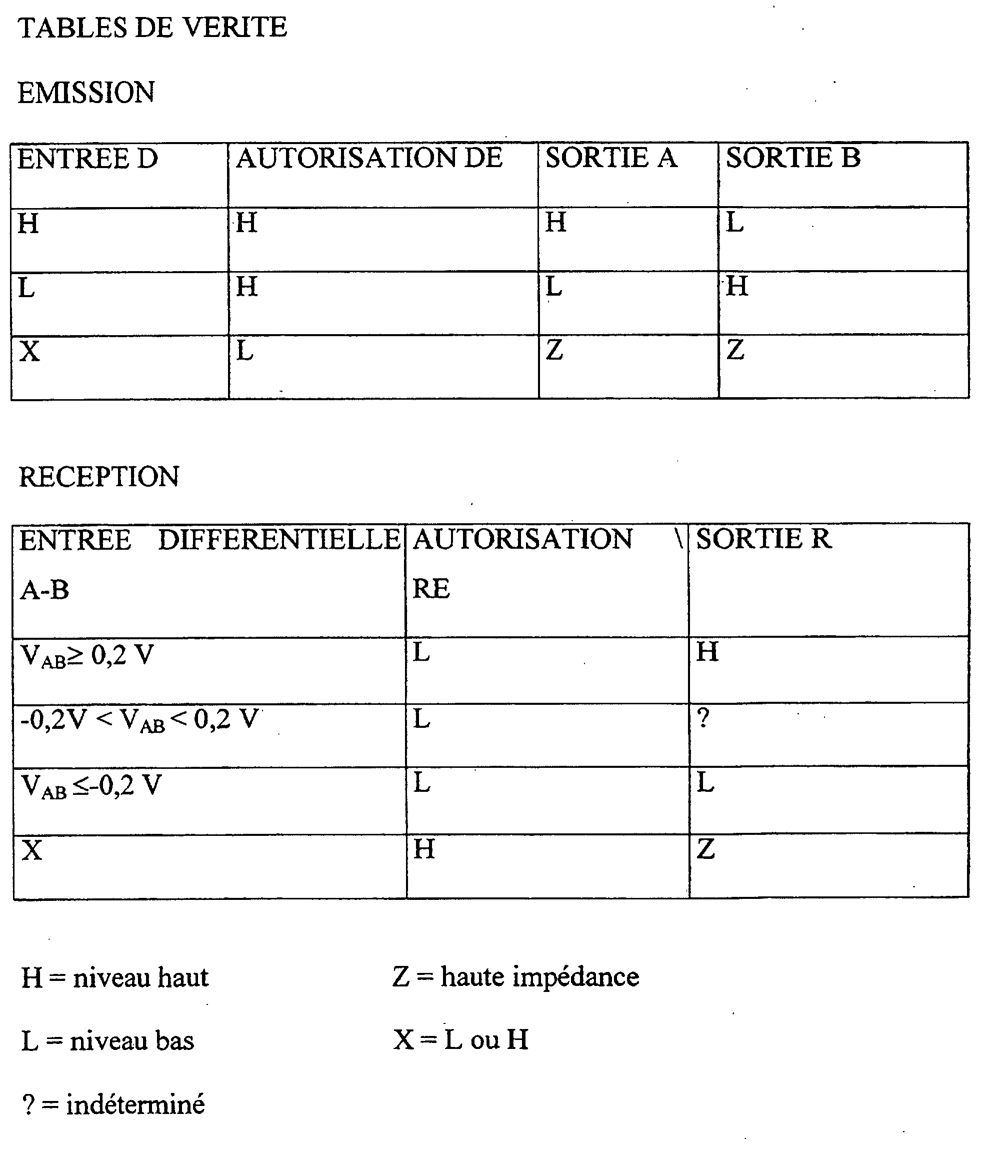

D'après ces tables de vérité, lorsque le signal de commande présent sur l'entrée de commande DE\RE est au niveau logique "1" ou "haut" (H), l'entrée de données D est validée et la sortie de données R est invalidée, c'est-à-dire qu'elle est en haute impédance. Dans ces conditions, le signal logique présent sur l'entrée D est transmis vers le bus de données 8,9 sous la forme d'un signal différentiel, la sortie A (conducteur 8 du bus) étant à tout instant dans le même état haut (H) ou bas (L) que l'entrée D, et la sortie B (conducteur 9 du bus) étant dans un état bas (L) ou haut (H) complémentaire de celui de l'entrée D.

Inversement, lorsque le signal de commande présent sur l'entrée de commande DE\RE est au niveau logique "0" ou "bas" (L), la sortie de données R est validée et l'entrée D est invalidée, les bornes A et B qui servent alors d'entrée étant en haute impédance. Dans ces conditions, un signal différentiel arrivant aux entrées A et B en provenance du bus de données 8,9 est transmis à la sortie R sous la forme d'un signal logique qui est à l'état haut (H) quand l'entrée différentielle V_{AB} est supérieure ou égale à une valeur de seuil positive, par exemple +0,2V, et qui est à l'état bas (L) quand l'entrée différentielle V_{AB} est inférieure ou égale à une valeur de seuil négative, par exemple -0,2V.

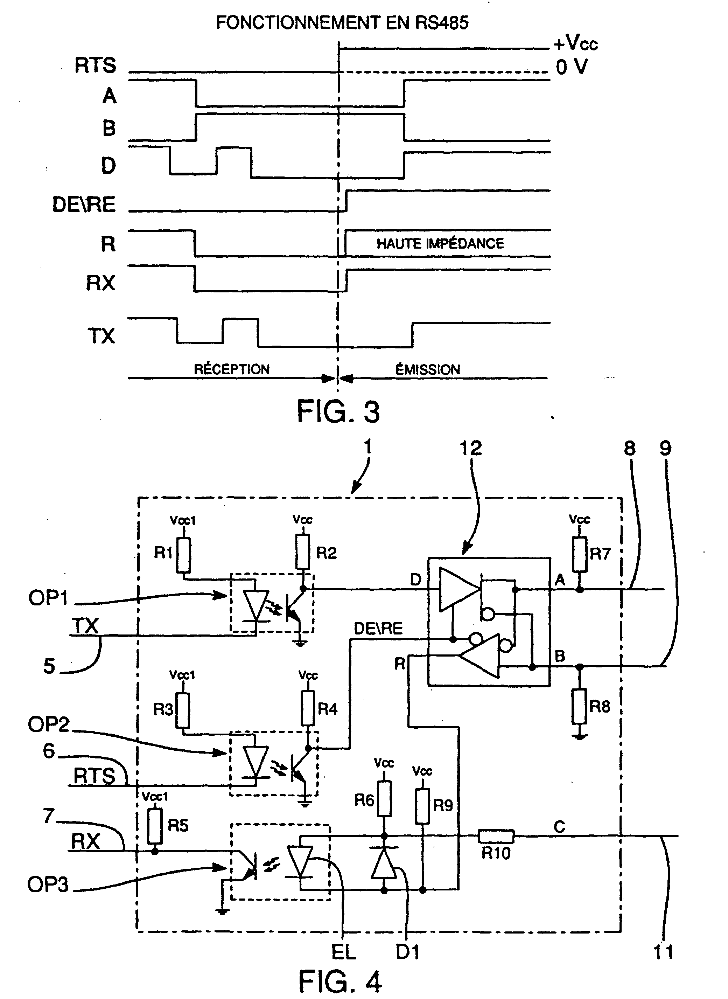

Le circuit d'interface 10 de la figure 2 fonctionne alors de la manière illustrée par le chronogramme de la figure 3. Les signaux illustrés dans ce chronogramme sont désignés par les mêmes symboles de référence que ceux des points où ils apparaissent dans le circuit d'interface 10 de la figure 2, et ils sont représentés en prenant la masse comme référence de potentiel (0V), comme cela est indiqué pour le signal RTS dans la figure 3.

Lorsque le signal de commande RTS provenant de l'émetteur-récepteur 2 de la figure 1 est au niveau logique "0", le système est en réception (voir la partie gauche du chronogramme de la figure 3). C'est-à-dire que le signal différentiel arrivant par le bus de données 8, 9 à la paire d'entrées A et B est transmis sous la forme du signal logique RX à l'émetteur-récepteur 2. Inversement, lorsque le signal de commande RTS est au niveau logique "1", le système est en émission (voir la partie droite du chronogramme de la figure 3). C'est-à-dire que le signal logique TX émis par l'émetteur-récepteur est transmis sous la forme d'un signal différentiel aux sorties A et B et, de là, au bus de données 8,9.

La figure 4 montre le circuit d'interface 1 selon l'invention. Dans la figure 4, les éléments qui sont identiques ou qui jouent le même rôle que ceux du circuit d'interface 10 de la figure 2 sont désignés par les mêmes numéros de référence et ne seront pas décrits à nouveau en détail. Le circuit d'interface 1 de la figure 4 diffère du circuit d'interface 10 de la figure 2 en ce qu'il comporte deux résistances supplémentaires R₉ et R₁₀. La résistance R₉ relie à la source de tension continue Vcc l'une des électrodes (la cathode) de l'émetteur de lumière EL (par exemple une diode émettrice) du troisième coupleur opto-électronique OP3, qui est raccordée à la sortie R du convertisseur 12. L'une des extrémités de la résistance R₁₀ est connectée à l'autre électrode de la diode émettrice de lumière EL du coupleur opto-électronique OP3, qui est raccordée à la source de tension continue Vcc par la résistance R₆. L'autre extrémité de la résistance R₁₀ peut être raccordée par le conducteur 11 à l'une des broches du connecteur 3 (figure 1). De préférence, une diode de protection D1 est montée tête-bêche aux bornes de la diode émettrice de lumière EL du coupleur opto-électronique OP3.

A titre d'exemple, pour une vitesse de transmission de 9600 Bauds, les composants du circuit d'interface 1 de la figure 4 peuvent avoir les valeurs suivantes :

| | |
|---|---|
| R₁ = 2,7 kΩ | V_{cc} = + 5V |
| R₂ = 4,7 KΩ | V_{cc1} = + 5V |
| R₃ = 2,7 kΩ | OP1 = TLP120 |
| R₄ = 4,7 kΩ | OP2 = TLP120 |
| R₅ = 22 kΩ | OP3 = TLP112 |
| R₆ = 4,7 kΩ | D1 = BAS 16 |
| R₇ = 470 kΩ | Circuit 12 = 75176 |
| R₈ = 470 kΩ | |
| R₉ = 2,7 kΩ | |
| R₁₀ = 2,7 kΩ | |

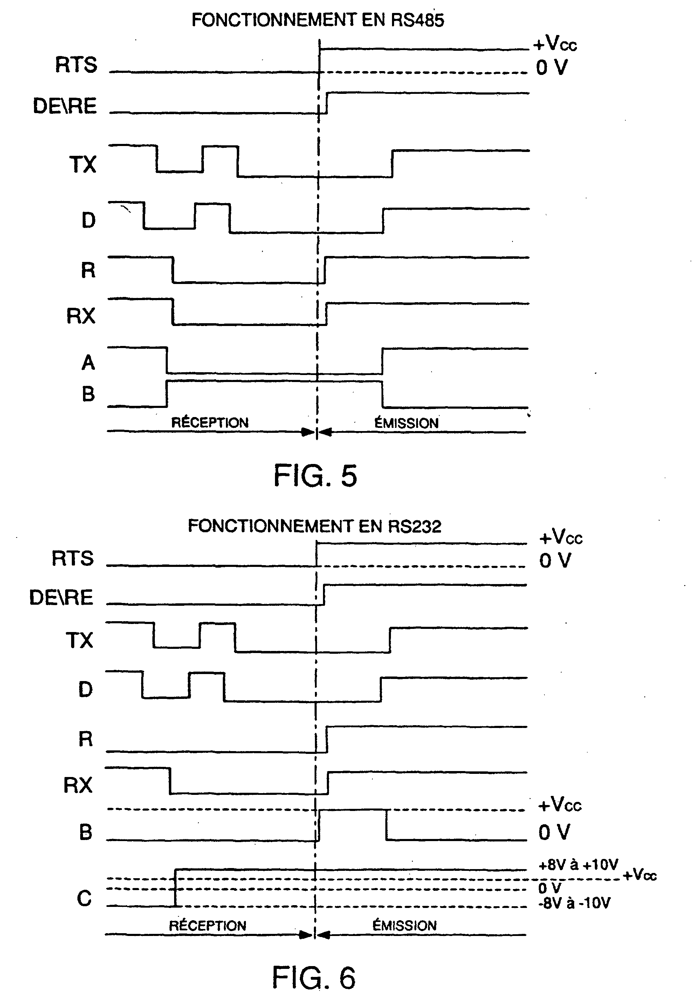

Pour un fonctionnement en liaison série RS485, seules les entrées/sorties A et B du circuit convertisseur 12 du circuit d'interface 1 de la figure 4 sont raccordées respectivement par les conducteurs 8 et 9 au connecteur 3 du câble 4 et l'extrémité C de la résistance R10 n'est pas raccordée au connecteur. Dans ce cas, le circuit d'interface 1 de la figure 4 fonctionne exactement de la même manière que le circuit d'interface connu 10 de la figure 2, comme cela est illustré par le chronogramme de la figure 5 qui est identique au chronogramme de la figure 3. En conséquence, le fonctionnement du circuit d'interface 1 en liaison série RS485 ne sera pas décrit à nouveau, étant donné qu'il suffit de se référer à la description faite plus haut à propos des figures 2 et 3.

Pour un fonctionnement en liaison série RS232, non seulement les deux entrées/sorties A et B du circuit convertisseur 12 du circuit d'interface 1 sont raccordées par les conducteurs 8 et 9 à deux des broches du connecteur 3, mais également l'extrémité C de la résistance R₁₀ est raccordée par le conducteur 11 à une troisième broche du connecteur 3. Par exemple, si le connecteur 3 est un connecteur standardisé du type DB25, les conducteurs 8,9 et 11 sont raccordés respectivement à la broche n°7, à la broche n°2 et à la broche n°3 de ce connecteur. Les numéros de broche sus-indiqués correspondent aux numéros réels des broches du connecteur. Si le connecteur 3 un connecteur standardisé du type DB9, les conducteurs 8, 9 et 11 seront raccordés respectivement à la broche n°5, à la broche n°3 et à la broche n°2 dudit connecteur.

La figure 6 est un chronogramme illustrant le fonctionnement du circuit d'interface 1 de la figure 4 pour une liaison série RS232. Dans la figure 6, les signaux RTS, DE\RE, TX, D, R et RX sont représentés en prenant la masse comme référence de potentiel (0V), tandis que les signaux B et C qui apparaissent respectivement en B et C dans le circuit d'interface 1 de la figure 4, sont référencés par rapport à la broche du connecteur 3 qui est raccordée au conducteur 8 (entrée/sortie A du circuit convertisseur 12).

Comme précédemment, lorsque le signal de commande RTS émis par l'émetteur-récepteur 2 est actif (niveau logique "1"), l'émission est validée et la réception invalidée. Inversement, lorsque le signal RTS est inactif (niveau logique "0"), l'émission est invalidée et la réception validée.

L'émission en RS232 (voir la partie droite du chronogramme de la figure 6) s'effectue sur la sortie B du circuit convertisseur 12 qui est référencée par rapport à l'entrée/sortie A. Plus précisément, lorsque le signal TX émis par l'émetteur-récepteur 2 est actif (masse ou 0V), le signal B sera actif (tension positive en émission RS232) tandis que, lorsque le signal TX est inactif (Vcc), le signal B sera inactif (tension négative en émission RS232), comme montré dans la partie droite du chronogramme de la figure 6.

La réception en RS232 (voir la partie gauche du chronogramme de la figure 6) s'effectue sur le conducteur 11 (signal C), tout en étant référencée par rapport à la broche du connecteur 3 qui est raccordée au conducteur 8 (entrée/sortie A). Plus précisément, lorsque le signal C arrivant sur le conducteur 11 a un niveau passif ou inactif (tension négative en réception RS232), il bloquera le coupleur opto-électronique OP3, de sorte que le signal RX prend un niveau logique "1". Inversement, lorsque le signal C a un niveau actif (tension positive en réception RS232), il fera conduire le coupleur opto-électronique OP3, de sorte que le signal RX prend un niveau logique "0" comme montré dans la partie gauche du chronogramme de la figure 6.

Ainsi, d'après ce qui précède, on voit que le circuit d'interface 1 selon l'invention, obtenu en ajoutant simplement deux résistances (R₉ et R₁₀) au circuit d'interface connu 10 de la figure 2, peut être utilisé pour émettre et recevoir des données conformément au standard RS485 ou conformément au standard RS232 simplement en changeant le câblage du connecteur 3. En pratique, il suffit de prévoir un premier câble 4 muni d'un connecteur 3 dont deux des broches sont raccordées respectivement aux conducteurs 8 et 9 pour une transmission selon le standard RS485, et un second câble 4 muni d'un connecteur 3 dont trois des broches sont raccordées respectivement aux conducteurs 8, 9 et 11 pour une transmission selon le standard RS232. Ainsi, le circuit d'interface selon l'invention pourra être raccordé à des machines ou appareils prévus pour communiquer selon le standard RS485 en utilisant le premier câble, ou à des machines ou appareils prévus pour communiquer selon le standard RS232 en utilisant le second câble. Ceci représente un grand avantage dans la mesure où il n'est plus nécessaire de changer une carte dans le système hôte, dans lequel est incorporé le circuit d'interface selon l'invention, pour que ce système hôte puisse communiquer avec des machines ou appareils externes ou éloignés selon le standard RS485 ou le standard RS232.

Il va de soi que le mode de réalisation qui a été décrit ci-dessus, a été donné à titre de d'exemple purement indicatif et nullement limitatif et que diverses modifications peuvent être apportées par l'homme de l'art sans pour autant sortir du cadre de l'invention. C'est ainsi notamment que les valeurs des tensions continues, les valeurs ohmiques des résistances R1 à R10, les composants électroniques OP1, OP2, OP3, D1 et le circuit convertisseur 12 peuvent être différents de ceux qui ont été indiqués plus haut, ces valeurs et composants pouvant dépendre de divers paramètres, en particulier de la vitesse désirée de transmission des données, la longueur maximale du câble 4 à utiliser, etc...

## Revendications

1. Circuit d'interface permettant de transmettre de manière bidirectionnelle des informations entre un émetteur-récepteur asynchrone universel (2) et un câble multiconducteur de liaison série (4), comprenant, côté émetteur-récepteur, un premier, un second et un troisième coupleur opto-électronique (OP1-OP3) et, côté câble de liaison, un circuit convertisseur (12) apte à convertir des signaux logiques (TX) provenant de l'émetteur-récepteur (2) en signaux logiques différentiels (A ― B) à destination d'une paire de conducteurs du câble de liaison (4) et, inversement, des signaux logiques différentiels (A ― B) provenant de ladite paire de conducteurs dudit câble de liaison (4) en signaux logiques (RX) à destination dudit émetteur-récepteur (2), conformément au standard RS485, ledit circuit convertisseur (12) comportant :
a) une entrée de données (D) pour recevoir, via le premier coupleur opto-électronique (OP1), lesdits signaux logiques de données (TX) provenant de l'émetteur-récepteur (2);
b) une entrée de commande (DE\RE) pour recevoir, via le second coupleur opto-électronique (OP2), des signaux de commande (RTS) en provenance de l'émetteur-récepteur;
c) une sortie de données (R) pour envoyer , via le troisième coupleur opto-électronique (OP3), lesdits signaux de données (RX) à l'émetteur-récepteur (2), ladite sortie (R) étant connectée à une première électrode d'un émetteur de lumière (EL) du troisième coupleur opto-électronique (OP3), une seconde électrode dudit émetteur de lumière étant reliée par une première résistance (R₆) à une source de tension continue (Vcc) ;
d) une première entrée/sortie (A) reliée à ladite source continue (Vcc) par une seconde résistance (R₇) et destinée à être connectée directement à une première broche d'un connecteur (3) reliant le circuit d'interface (1) audit câble de liaison (4); et
e) une seconde entrée/sortie (B) reliée à une masse électrique par une troisième résistance (R₈) et destinée à être connectée directement à une seconde broche du connecteur (3);
**caractérisé en ce que** la première électrode dudit émetteur de lumière (EL) du troisième coupleur opto-électronique (OP3) est reliée par une quatrième résistance (R₉) à ladite source de tension continue (Vcc), et **en ce que** la seconde électrode dudit émetteur de lumière (EL) est reliée à une première extrémité d'une cinquième résistance (R₁₀), dont la seconde extrémité (C) est destinée à être raccordée directement à une troisième broche du connecteur (3), grâce à quoi, en prenant comme référence de potentiel la première entrée/sortie (A) dudit circuit convertisseur (12), le circuit d'interface (1) est apte à émettre, sur la deuxième entrée/sortie (B) du circuit convertisseur (12), des signaux logiques de données conformes au standard RS232, et à recevoir sur la seconde extrémité (C) de la cinquième résistance (R₁₀), des signaux logiques de données conformes au standard RS232.

2. Circuit d'interface selon la revendication 1, **caractérisé en ce que** ledit émetteur de lumière (EL) est une diode émettrice et **en ce qu'**une diode de protection (D1) est montée tête-bêche aux bornes de la diode émettrice.

## Patentansprüche

1. Schnittstellenschaltung, mit der sich Informationen zwischen einem universellen asynchronen Sender-Empfänger (2) und einem Mehrleiterkabel für serielle Verbindungen (4) in zwei Richtungen übertragen lassen, auf der Sender-Empfänger-Seite umfassend einen ersten, zweiten und dritten optoelektronischen Koppler (OP1-OP3) und auf der Verbindungskabelseite umfassend eine Wandlerschaltung (12) für die Umwandlung von Logiksignalen (TX), die von einem Sender-Empfänger (2) stammen, in differentielle Logiksignale (A - B) für ein Leitungspaar (4) des Verbindungskabels und umgekehrt von differentiellen Logiksignalen (A - B), die von diesem Leitungspaar (4) des Verbindungskabels stammen, in Logiksignale (RX) für den Sender-Empfänger (2) gemäß RS485-Standard, wobei die Wandlerschaltung (12) folgendes aufweist:
a) einen Dateneingang (D) zum Empfangen der logischen Datensignale (TX), die vom Sender-Empfänger (2) stammen, über den ersten optoelektronischen Koppler (OP1);
b) einen Steuereingang (DE\RE) zum Empfangen von Steuersignalen (RTS), die vom Sender-Empfänger stammen, über den zweiten optoelektronischen Koppler (OP2);
c) einen Datenausgang (R) zum Senden der Datensignale (RX) über den dritten optoelektronischen Koppler (OP3) an den Sender-Empfänger (2), wobei der Ausgang (R) an eine erste Elektrode eines Lichtsenders (LE) des dritten optoelektronischen Kopplers (OP3) angeschlossen ist, wobei eine zweite Elektrode des Lichtsenders über einen ersten Widerstand (R₆) mit einer Gleichstromquelle (Vdc) verbunden ist;
d) einen ersten Eingang/Ausgang (A), der über einen zweiten Widerstand (R₇) mit der Gleichstromquelle (Vdc) verbunden ist und dazu bestimmt ist, direkt an eine ersten Klemme eines Verbindungselements (3) angeschlossen zu werden, das die Schnittstellenschaltung (1) mit dem Verbindungskabel (4) verbindet; und
e) einen zweiten Eingang/Ausgang (B), der über einen dritten Widerstand (R₈) mit einer elektrischen Masse verbunden ist und dazu bestimmt ist, direkt an eine zweite Klemme des Verbindungselements (3) angeschlossen zu werden;
**dadurch gekennzeichnet, dass** die erste Elektrode des Lichtsenders (LE) des dritten optoelektronischen Kopplers (OP3) über einen vierten Widerstand (R₉) an die Gleichstromquelle (Vdc) angeschlossen ist, und dass die zweite Elektrode des Lichtsenders (LE) mit einem ersten Ende eines fünften Widerstands (R₁₀) verbunden ist, dessen zweites Ende (C) dazu bestimmt ist, direkt an eine dritte Klemme des Verbindungselements (3) angeschlossen zu werden, wodurch, wenn der erste Eingang/Ausgang (A) der Wandlerschaltung (12) als Potentialreferenz gewählt wird, die Schnittstellenschaltung (1) in der Lage ist, am zweiten Eingang/Ausgang (B) der Wandlerschaltung (12) logische Datensignale gemäß RS232-Standard zu senden und an dem zweiten Ende (C) des fünften Widerstands (R₁₀) logische Datensignale gemäß RS232-Standard zu empfangen.

2. Schnittstellenschaltung entsprechend Anspruch 1, **dadurch gekennzeichnet, dass** der Lichtsender (LE) eine Senderdiode ist, und dass eine Schutzdiode (D1) an den Klemmen der Senderdiode in entgegengesetzter Richtung montiert ist.

## Claims

1. An interface circuit enabling bi-directional transmitting of information between an asynchronous universal transceiver (2) and a multiconductor serial connection cable (4), comprising, on the transceiver side, a first, a second and a third optoelectronic coupler (OP1-OP3) and, on the connection cable side, a convertor circuit (12) apt to convert logical signals (TX) coming from the transceiver (2) into differential logical signals (A-B) intended for a couple of conductors in the connection cable (4) and, inversely, to convert differential logical signals (A-B) coming from said couple of conductors in said connection cable (4) into logical signals (RX) intended for said transceiver (2), in conformity with standard RS485, said convertor circuit (12) comprising :
a) a data input (D) receiving, via the first optoelectronic coupler (OP1), said logical data signals (TX) coming from the transceiver (2);
b) a control input (DE/RE) receiving, via the second optoelectronic coupler (OP2), control signals (RTS) coming from the transceiver;
c) a data output (R) for transmitting, via the third optoelectronic coupler (OP3), said data signals (RX) to the transceiver (2), said output (R) being connected to a first electrode of a light emitter (EL) of the third optoelectronic coupler (OP3), a second electrode of said light emitter being connected by a first resistor (R₆) to a direct-current source (Vcc);
d) a first input/output (A) connected to said direct-current source (Vcc) by a second resistor (R₇) and intended to be connected directly to a first pin of a connector (3) connecting the interface circuit (1) to the connection cable (4); and
e) a second input/output (B) connected to electrical earth by a third resistor (R₈) and intended to be connected directly to a second pin of the connector (3);
**characterised by** the first electrode of said light emitter (EL) of the third optoelectronic coupler (OP3) being connected by a fourth resistor (R₉) to said direct-current source (Vcc), and by the second electrode of said light emitter (EL) being connected to a first end of a fifth resistor (R₁₀), the second end (C) of which is intended for being connected directly to a third pin of the connector (3), thanks to which, by choosing the first input/output (A) of said convertor circuit (12) as a reference potential, the interface circuit (1) is apt to transmit, through the second input/output (B) of the convertor circuit (12), logical data signals in conformity with standard RS232, and to receive through the second end (C) of the fifth resistor (R₁₀), logical data signals in conformity with standard RS232.

2. The interface circuit as claimed in claim 1, **characterised by** said light emitter (EL) being a diode emitter and by a protection diode (D1) being mounted inverted at the terminals of the emitter diode.
